# EUROPEAN PATENT SPECIFICATION

(11) **EP 0 390 944 B1**
(45) Date of publication and mention of the grant of the patent: **30.06.1999**
(21) Application number: 89105911.5
(22) Date of filing: 04.04.1989
(51) Int. Cl.: H01L 23/538

(54) **Manufacturing method for a multilayer ceramic substrate**
Herstellungsprozess für ein keramisches mehrschichtiges Substrat
Méthode de production d'un substrat céramique multicouche

(43) Date of publication of application: 10.10.1990
(73) Proprietor: Murata Manufacturing Co., Ltd., Nagaokakyo-shi Kyoto-fu (JP)
(72) Inventor: More, Yoshiaki c/o Murata Manufacturing Co., Ltd., Nagaokakyo-shi Kyoto-fu (JP); Takagi, Hiroshi c/o Murata Manufacturing Co., Ltd., Nagaokakyo-shi Kyoto-fu (JP); Sakabe, Yukio c/o Murata Manufacturing Co., Ltd., Nagaokakyo-shi Kyoto-fu (JP)
(74) Representative: Grosse, Wolfgang, Dipl.-Ing.

(56) References cited:
- EP-A- 0 082 515
- EP-A- 0 212 124
- EP-A- 0 292 125
- US-A- 3 879 509
- WESCON TECHNICAL PAPERS, vol. 14, 1970, pages 1-6, California, L.A., US; G. GOULD et al.: "Multichip multilevel thick film packaging"

## Description

### Field of the Invention

The present invention relates to a multilayer ceramic substrate and its manufacturing method, particularly, it relates to a multilayer ceramic substrate having circuit elements, for example, such as a capacitor, resistor and so on between insulator substrates and its manufacturing method.

### Description of the Prior Art

Generally, with the development of small-sized electronic equipments, a multilayer high density ceramic substrate has also been realized. As such multilayer ceramic substrate, for example, as disclosed in Japanese Patent Application Laid Open No. 56204/1987, a multilayer ceramic substrate having circuit elements such as a capacitor, resistor, inductor and so on is constituted by preparing a plurality of ceramic green sheets printed with thick films of dielectric paste, resistor paste, conductor paste etc., laminating and pressurizing the green sheets and firing the same.

In such conventional multilayer ceramic substrate, however, when each ceramic green sheet printed with paste is laminated and pressed, gaps are liable to form on the side of the portion where the pastes are printed, not only, causing the paste printed surface to delaminate easily during firing, but deteriorating the substrate smoothness as repeating lamination of the ceramic green sheet after painting the pastes, which results in difficulties when mounting the electronic elements on the fired substrate surface.

EP-A-0 292 124 discloses a multilayer superconducting circuit substrate and a process for manufacturing the same. In this process a multilayer substrate is obtained which encloses insulating layers and interconnecting patterns of a superconductive ceramic material located between the insulating layers. The document addresses to the problem of sandwiching superconductive interconnecting patterns wherein said pattern only consists of conductors. The thickness of the conductors is specified to lie preferably in the range of 20 - 40 µm.

EP-A-0 212 124 discloses a method for fabricating a multilayer ceramic network. The so-called "circuit network" only includes conductors to be stacked in a plurality of green ceramic sheets. Since the thickness of the stacked patterns could sum up to a condsiderable size, frame-like sheets are disposed along the edge of the substrate in order to avoid bending of the stack.

### SUMMARY OF THE INVENTION

It is an object of the present invention to provide a method for manufacturing a multilayer ceramic substrate which is hardly delaminated during firing and has a good smoothness.

These problems are solved by the features of claim 1.

A multilayer ceramic substrate fabricated according to the present invention is a multilayer ceramic substrate including an insulator substrate, a circuit element formed on a portion of one main surface of the insulator substrate, an insulator spacer formed, at least, on the other portion of one main surface of the insulator substrate to form a generally smooth surface in cooperation with the circuit element, and a separate insulator substrate formed on the smooth surface.

A method for manufacturing a multilayer ceramic substrate according to the present invention is the method for manufacturing the multilayer ceramic substrate comprising, a process for preparing a ceramic green sheet formed into the insulator substrate by firing, a process for forming a circuit element paste layer formed into the circuit element by firing on a portion of one main surface of the ceramic green sheet, a process for forming an insulator material layer formed into the insulator spacer by firing, at least, on the other portion of one main surface of the ceramic green sheet and on said circuit element paste so as to form a generally smooth surface in cooperation with the circuit element paste layer, a process for preparing a separate ceramic green sheet formed into the separate insulator substrate by firing, a process for forming a laminate by laminating the separate ceramic green sheet on the smooth surface, and a process for pressing and firing the laminate.

Gaps are not formed on the side of the circuit element between the insulator substrates by the insulator spacer. Besides, the thickness between the insulator substrates is formed generally in constant by the insulator spacer.

According to the present invention, since the gaps are not formed on the side of the circuit element, delamination between the layers during firing can be prevented. In addition, since the thickness between the insulator substrates is formed generally in constant, the smoothness of multilayer ceramic substrate after firing can be maintained. Accordingly, electronic elements can be easily mounted on the multilayer ceramic substrate and a multilayer high-density substrate can be better realized.

The above and other objects, features, aspects and advantages of the present invention will become more apparent form the following detailed description of the embodiments made in connection with the accompanying drawings.

### BRIEF DESCRIPTION OF THE DRAWINGS

Figs. 1A to 1D respectively show one illustrative product in which Fig. 1A is a perspective view, Fig. 1B is an exploded perspective view, Fig. 1C is a sectional view taken along the line IC-IC of Fig. 1A and Fig. lD is a sectional view taken along the line ID-ID of Fig. 1A.
Fig. 2A is an equivalent circuit diagram of the illustrative product shown in Figs. 1A to 1D.
Figs. 3A to 3D respectively show one example of a process for manufacturing the illustrative product shown in Figs. 1A to 1D, in which Figs. 3A, 3B and 3D are respective plan views and Fig. 3C is a sectional view taken along the line IIIC-IIIC of Fig. 3B.
Figs. 4A to 4C show another example of a process for manufacturing the illustrative product shown in Figs. 1A to 1D, in which Figs. 4A and 4B are respective plan views and Fig. 4C is a sectional view taken along the line IVC-IVC of Fig. 4B.
Fig. 5 shows an example of, in particular, modified draw-out portion of an electrode of the illustrative product shown in Figs. 1A to 1D, in which Fig. 5 corresponds to a sectional view taken along the line V-V of Fig. 1A.
Figs. 6A to 6C respectively show a product of the present invention, in which Fig. 6A is a perspective view, Fig. 6B is a sectional view taken along the line VIB-VIB of Fig. 6A and Fig. 6C is a sectional view taken along the line VIC-VIC of Fig. 6A.
Figs. 7A to 7D respectively show an example of a process for manufacturing the product shown in Figs. 6A to 6C, in which Figs. 7A, 7B and 7D are respective plan views and Fig. 7C is a sectional view taken along the line VIIC-VIIC of Fig. 7B.

### DESCRIPTION OF THE PREFERRED EMBODIMENTS

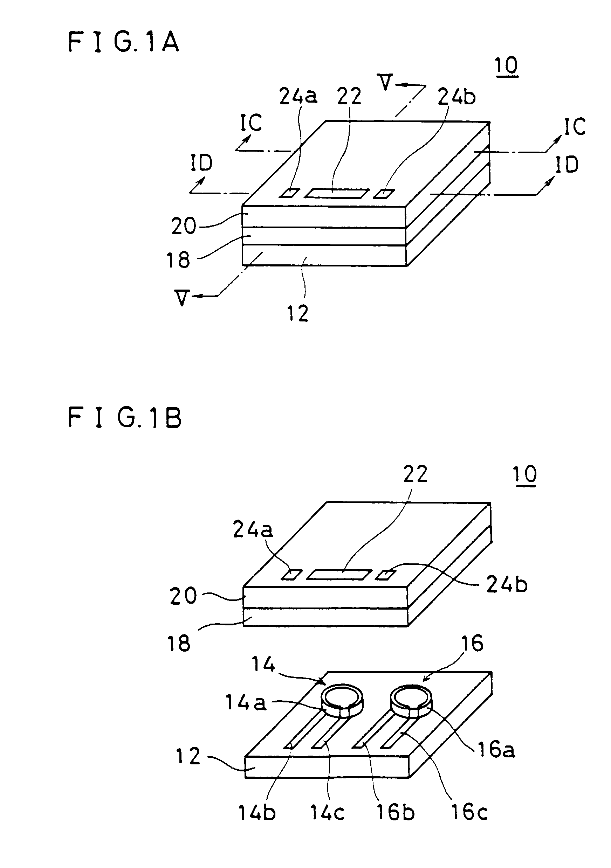

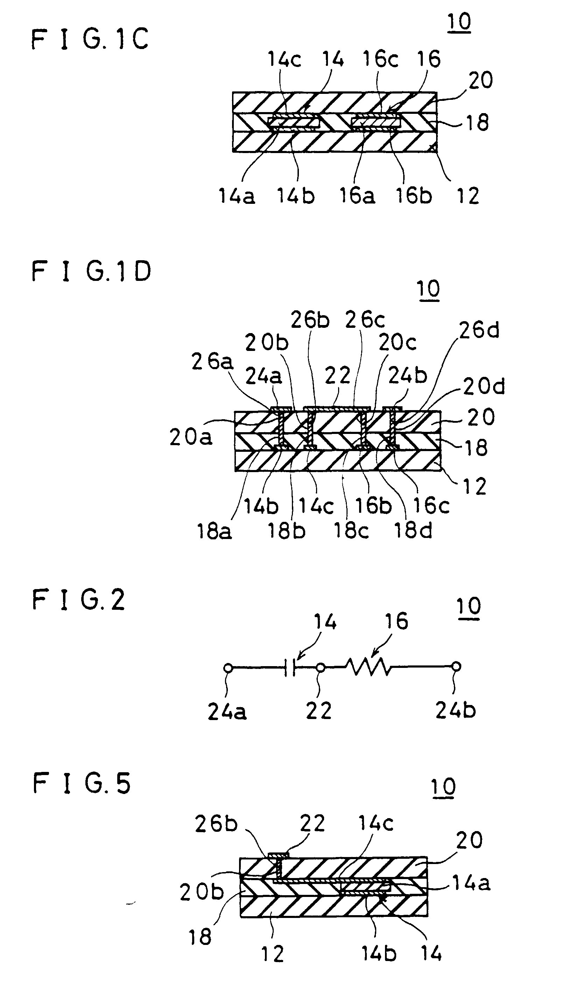

Figs. 1A to 1D respectively show one illustrative product, in which Fig. 1A is a perspective view, Fig. 1B is its exploded perspective view, Fig. 1C is a sectional view taken along the line IC-IC of Fig. 1A and Fig. 1D is a sectional view taken along the line ID-ID of Fig. 1A. The multilayer ceramic substrate 10 includes an insulator substrate 12 consisting of ceramics.

On a portion of one main surface of the insulator substrate 12, as shown in Fig.1B, a capacitor 14 and resistor 16 as circuit elements are formed in spaced intervals.

The capacitor 14 includes, for example, a disc dielectric element 14a, on both surfaces of which electrodes 14b and 14c having draw-out portions are formed respectively. The electrode 14b, dielectric element 14a and electrode 14c of the capacitor 14 are formed on the insulator substrate 12 in this order. In this case, the draw-out portion of the electrode 14c is extended on one surface of the insulator substrate 12.

The resistor 16 includes, for example, a disc resistor element 16a, on both surfaces of which, also electrodes 16b and 16c having draw-out portions are formed respectively. The electrode 16b, resistor element 16a and electrode 16c are formed on the insulator substrate 12 in this order. In this case, the draw-out portion of the electrode 16c is also extended on one main surface of the insulator substrate 12.

Furthermore, on the other portion of one surface of the insulator substrate 12, an insulator spacer 18 is formed by the same ceramic material as the insulator substrate 12. In this case, the insulator spacer 18, as shown particularly in Fig. 1C, is formed on the side of the capacitor 14 and resistor 16 such that, the thickness is generally as same as the capacitor 14 and resistor 16 and its surface is generally flush with those of the capacitor 14 and resistor 16. In the insulator spacer 18, as particularly shown in Fig. 1D, through holes 18a, 18b, 18c and 18d are formed at the portions opposed to the draw-out portions of the electrodes 14b, 14c, 16b and 16c of the capacitor 14 and resistor 16.

Meanwhile, on the capacitor 14, resistor 16 and insulator spacer 18, a separate insulator substrate 20 is formed by the same ceramic material as the insulator substrate 12. In the insulator substrate 20, as shown in Fig. 1D, through holes 20a, 20b, 20c and 20d are formed respectively so as to communicate with the through holes 18a, 18b, 18c and 18d of the insulator spacer 18. Moreover, on the surface of the insulator substrate 20, a connecting electrode 22 is formed entirely between the surroundings of through holes 20b and 20c, and outer electrodes 24a and 24b are formed respectively around the through holes 20a and 20d.

The draw-out portion of the electrode 14c of the capacitor 14 and one end of the connecting electrode 22 are connected electrically by a conductor 26b in the through hole 18b of the insulator spacer 18 and the through hole 20b of the insulator substrate 20. Similarly, the electrode 16b of the resistor 16 is connected to the other end of the connecting electrode 22 by a conductor 26c in the through holes 18c and 20c. Thus, one end of the capacitor 14 and one end of the resistor 16 is connected electrically.

Furthermore, the electrode 14b of the capacitor 14 and the outer electrode 24a are connected by a conductor 26a in the through holes 18a and 20a, and the electrode 16c of the resistor 16 and the outer electrode 24b are connected by a conductor 26d in the through holes 18d and 20d.

Accordingly, the multilayer ceramic substrate 10, as shown in Fig. 2, shows an equivalent circuit configuration in which one capacitor 14 and one resistor 16 are connected in series.

Though the multilayer ceramic substrate 10 is manufactured by entirely firing the materials such as the capacitor 14 and resistor 16 pressed between a ceramic green sheet formed into the insulator substrate 12 and a separate ceramic green sheet formed into the separate insulator substrate 20, since a material formed into the insulator spacer 18 is also pressed between the ceramic green sheets which are formed into the insulator substrates 12 and 20, gaps are not formed on the side of the materials formed into circuit elements. Therefore, delamination between the layers hardly occur during firing. Besides, in the multilayer ceramic substrate 10, as the capacitor 14, resistor 16 and insulator spacer 18 are formed generally into a constant thickness between the insulator substrates 12 and 20, its surface is very smooth, thus the electronic elements can be easily mounted on the surface thereof.

In the multilayer ceramic substrate 10, for example, when an IC is mounted on the surface and a capacitor for restraining noises is connected between power sources and IC, if the capacitor 14 incorporated is used as the capacitor, a space for mounting the capacity can be eliminated. In addition, in the multilayer ceramic substrate 10, if the IC is mounted immediately above the capacitor 14 incorporated, the length of conductor patterns for connecting the capacitor 14 and IC can be shortened, thus it can be used in a high frequency circuit having such a connection without any problem.

Next, an illustrative example, of a manufacturing method of the multilayer ceramic substrate 10 will be described.

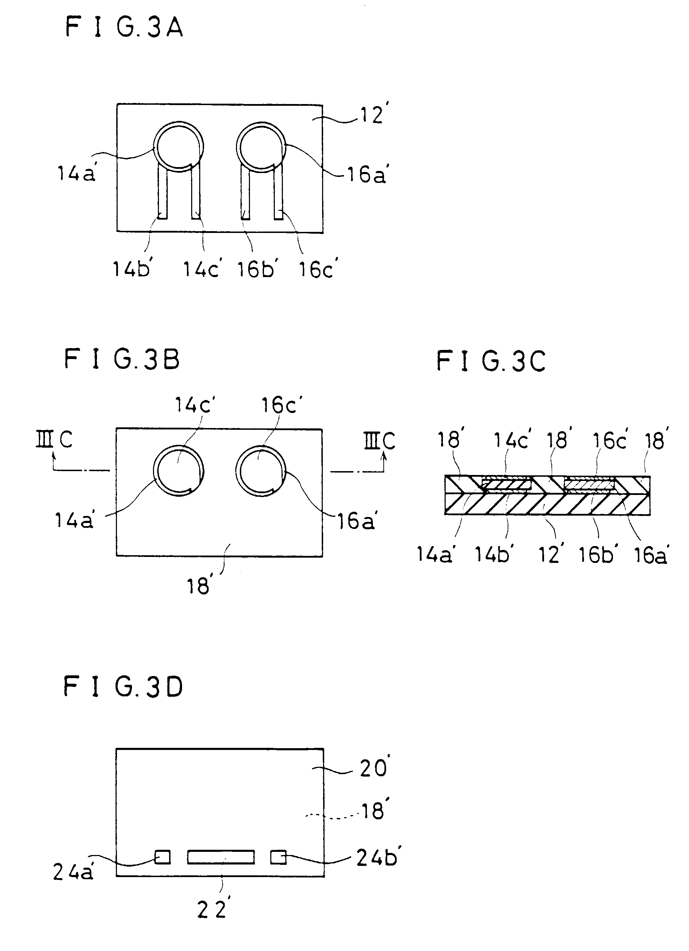

First, as shown in Fig. 3A, a ceramic green sheet 12' which is formed into the insulator substrate 12 by firing is prepared. As the ceramic green sheet 12', for example, as disclosed in Electronic Ceramics, Page 18 - 19, Mar., 1985, a mixture of ceramic powder composed of Al₂O₃, CaO, SiO₂, MgO, B₂O₃ and a very small amount of additives and a binder moulded into a sheet by a doctor blade process can be used. Characteristic deterioration of such a ceramic green sheet is minor, for example, when fired in a reducing atmosphere such as nitrogen, besides firing can be accomplished in a relatively low temperature of 900 - 1000°C.

Subsequently, on one main surface of the ceramic green sheet 12', conductive paste layers 14b' and 16b' which are formed into the electrode 14b of the capacitor 14 and the electrode 16b of the resistor 16 by firing, are formed respectively by printing and coating a conductive paste. As the conductive paste, compositions of base metals such as Cu, Ni, Fe etc. can be used since the ceramic green sheet 12' can be fired in the reducing atmosphere of 900 - 1000°C.

Meanwhile, on one main surface of the ceramic green sheet 12' including one end portion of the conductive paste layer 14b', a dielectric paste layer 14a' which is formed into the dielectric element 14a by firing is formed by printing and coating a dielectric paste. As the dielectric paste, for example, nonreducing dielectric pastes of barium titanate group as disclosed in Japanese Patent Application Laid Open No. 56204/1987 can be used. Characteristic deterioration of such dielectric paste is minor even when fired in a reducing atmosphere by containing it in the ceramic green sheet.

Also, on one main surface of the ceramic green sheet 12' including one end portion of the conductive paste layer 16b', a resistor paste layer 16a' which is formed into the resistor element 16a by firing is formed by printing and coating a resistor paste. As the resistor paste, for example, nonreducing resistance compositions composed of resistance substances such as lanthanum boride and yttrium boride and nonreducing glass as disclosed in Japanese Patent Application Laid Open No. 27700/1980 or No. 29199/1980 can be used. When such resistor paste is used, characteristic deterioration is minor even when it is contained in the ceramic green sheet and fired in the reducing atmosphere.

Moreover, on one main surface of the ceramic green sheet 12' including the surface of dielectric paste layer 14a' and resistor paste layer 16a', conductive paste layers 14c' and 16c' which are formed into the electrodes 14c and 16c by firing are formed respectively by printing and coating a conductive paste.

Next, on one main surface of the ceramic green sheet 12', as shown in Figs. 3B and 3C, an insulator paste layer 18' as an insulator material layer which is formed into the insulator spacer 18 by firing, is formed by printing and coating an insulator paste composed of the same material as the ceramic green sheet 12'.

The conductive paste layers, dielectric paste layer, resistor paste layer and insulator paste layer aforementioned are formed by using the thick-film technique and printing and coating respective pastes.

Furthermore, as shown in Fig. 3D, a separate ceramic green sheet 20' which is formed into the separate insulator substrate 20 by firing is prepared. A same material as the aforesaid ceramic green sheet 12' can be used for the ceramic green sheet 20'. On the surface of the ceramic green sheet 20', conductive paste layers 22', 24a' and 24b' which are formed into the connecting electrode 22, outer electrodes 24a and 24b by firing are formed respectively by printing and coating the conductive paste.

Then, the ceramic green sheet 20' is laminated on the insulator paste layer 18' and so on. Before the lamination, through not shown in Figs. 3B to 3D, in the insulator paste layer 18' and ceramic green sheet 20', through holes 18a - 18d and 20a - 20d are formed, in which the conductive paste which is formed into conductors 26a - 26d is filled.

By pressing and firing entirely, the multilayer ceramic substrate 10 shown in figs. 1A and 1D is obtained.

Next, another illustrative manufacturing method of the multilayer ceramic substrate 10 will be described.

In this method, it is different, in particular, in the point to form the insulator material layer which is formed into the insulator spacer 18 as follows, when compared to the aforesaid manufacturing process shown in Figs. 3A to 3D.

That is, in this method, the insulator material layer which is formed into the insulator spacer 18 is prepared as a ceramic green sheet 19. The ceramic green sheet 19 has the generally same thickness as the dielectric paste layer 14a' and resistor paste layer 16a' as shown in fig. 4A, and responsive to the dielectric paste layer 14a' and resistor paste layer 16a', through holes 19a and 19b generally as same size as those the former are formed therein.

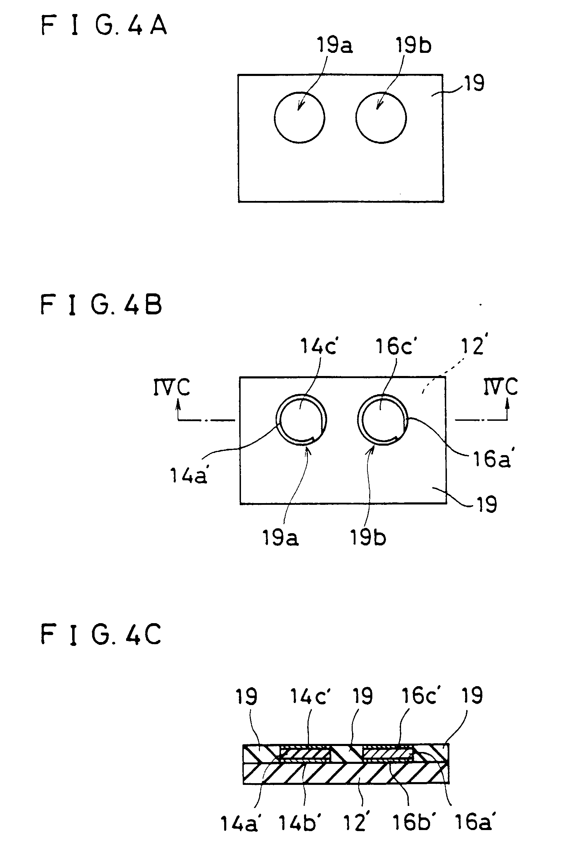

As shown in Figs. 4B and 4C, the ceramic green sheet 19 is laminated on the ceramic green sheet 12'.

Thereafter, as same as the method aforementioned, the ceramic green sheet 20' is laminated and pressed onto the ceramic green sheet 19 to obtain the multilayer ceramic substrate 10 by firing entirely.

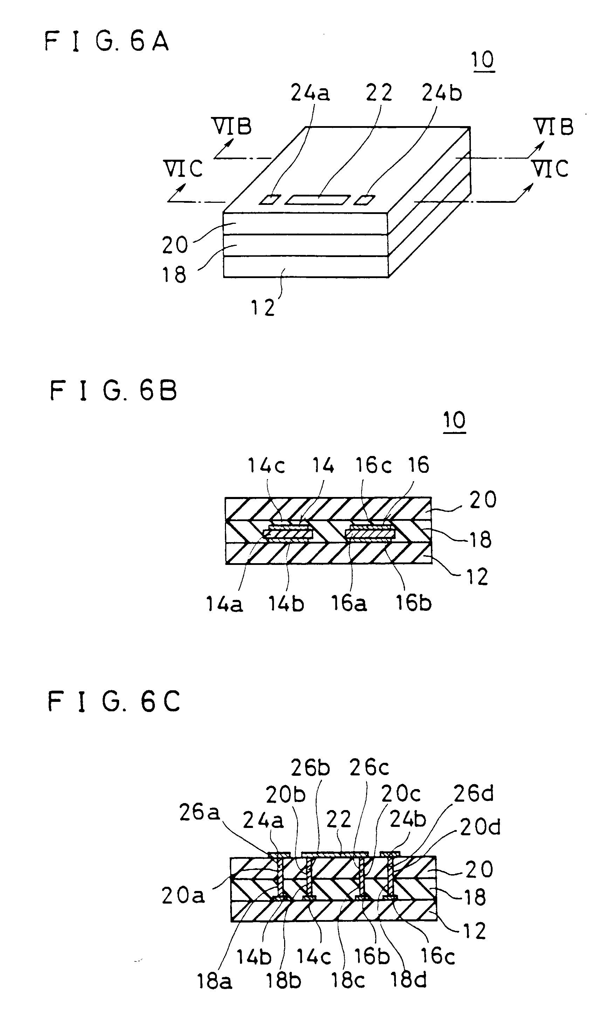

In the illustrative product aforementioned, the draw-out portion of the electrode 14c may be constructed as shown in Fig. 5, which corresponds to a sectional view taken along the line V-V of Fig. 1A. In the illustrative product shown in Fig. 5, the draw-out portion of the electrode 14c of the capacitor 14 is formed on a portion of one main surface of the insulator substrate 20. The draw-out portion is connected to the connecting electrode 22 on the surface of insulator substrate 20 by the conductor 26b in the through hole 20b formed in the insulator substrate 20. Similarly, though not shown, the draw-out portion of the electrode 16c of the resistor 16 is also, following the aforesaid example of draw-out portion of the electrode 14c, formed on a portion of one main surface of substrate 20 and connected to the outer electrode 24b by the conductor 26d in the through hole 20d formed in the insulator substrate 20 as shown Fig. 1D.

Fig. 6A to 6c respectively shows an product of the present invention, in which Fig. 6A is a perspective view, Fig. 6B is a sectional view taken along the line VIB-VIB of Fig. 6A and Fig. 6C is a sectional view taken along the line VIC- VIC of Fig. 6A. In the multilayer ceramic substrate 10 of this product, when compared to the products shown in Figs. 1A to 1D, in particular, the insulator spacer 18 is formed not only on the other portion of one main surface of the insulator substrate 12, but also on the capacitor 14 and resistor 16. In this case, the insulator spacer 18 is, in particular, so formed that its surface is generally smooth as shown in Fig. 1C. Therefore, the separate insulator substrate 20 is formed on the insulator spacer 18.

Also in the multilayer ceramic substrate 10, similar to the embodiment shown in Figs. 1A to 1D, one end of the capacitor 14 and resistor 16 are connected to the connecting electrode 22 and the other end of the capacitor 14 and resistor 16 are connected respectively to the outer electrodes 24a and 24b by the conductors 26a - 26d in the through holes 18a - 18d and 20a -20d. Thus, the multilayer ceramic substrate 10 also shows the circuit configuration in which one capacitor 14 and one resistor 16 are connected in series.

Though the multilayer ceramic substrate 10 is also manufactured by entirely firing respective pressed materials such as the ceramic green sheets which are formed into the insulator substrates and so on, since gaps are not formed between the ceramic green sheets which are formed into the insulator substrates 12 and 20, delamination between the layers during firing has hardly occurred. Besides, since the capacitor 14 and resistor 16 are covered by the insulator spacer 18 and become smooth between the insulator substrates 12 and 20, namely, their thickness is constant therebetween, the entire multilayer ceramic substrate 10 also becomes smooth. Therefore, electronic elements can be easily mounted on the surface of the multilayer ceramic substrate 10.

Next, an example of manufacturing process of the multilayer ceramic substrate 10 shown in figs. 6A to 6C will be described.

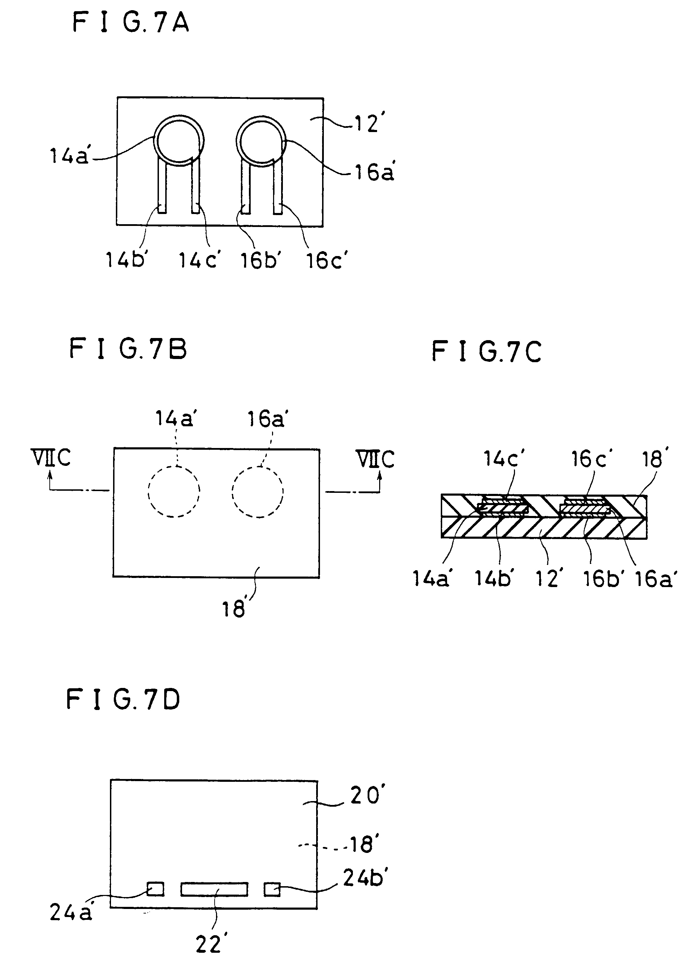

First, as shown in Fig. 7A, on one main surface of the ceramic green sheet 12' which is formed into the insulator substrate 12 by firing, respective paste layers 14a' - 14c' and 16a' -16c' which are formed into the capacitor 14 and resistor 16 by firing are formed. In this case, it is formed by the same process as those in the aforesaid respective manufacturing methods.

In this manufacturing method, as shown in Figs. 7B and 7C, in particular, on the ceramic green sheet 12', dielectric paste layer 14a' and resistor paste layer 16a', the insulator paste layer 18' as an insulator material layer which is formed into the insulator spacer 18 by firing, is formed by printing and coating an insulator paste composed of the same material as the ceramic green sheet 12'. As the insulator paste, preferably a material in which the leveling has been improved by adjusting the viscosity, vehicle compositions or squeegee pressure is used.

Thus, as shown in Fig. 7D, the separate ceramic green sheet 20' having conductive paste layers 22', 24a' and 24b' on its surface is laminated on the insulator paste layer 18'. Before the lamination, also in this embodiment, through holes 18a - 18d and 20a - 20d are formed respectively in the insulator paste layer 18' and ceramic green sheet 20', and a conductive paste which is formed into the conductors 26a - 26b is filled in these through holes as shown Fig. 1D.

Finally, a multilayer ceramic substrate 10 shown in Figs. 6A to 6C is obtained by pressing and firing entirely.

In this manufacturing method, though an insulator material layer which is formed into the insulator spacer 18 is formed by an insulator paste, the insulator material layer may be formed by a ceramic green sheet. In this case, the ceramic green sheet has the thickness thicker than the dielectric paste layer 14a' and resistor paste layer 16a', and corresponding thereto, recesses having generally the same size as those in the dielectric paste layer 14a' and resistor paste layer 16a' are formed. The ceramic green sheet is laminated on the ceramic green sheet 12' and so on. Thereafter, as same as the method aforementioned, the ceramic green sheet 20' is laminated and pressed onto the ceramic green sheet and fired entirely, thereby the multilayer ceramic substrate 10 is obtained.

### Example

First, 200 samples were prepared respectively, by a method A shown in Figs. 3A to 3D, a method B shown in Figs. 4A to 4C and a method C shown in Figs. 7A to 7D.

In this case, as a ceramic green sheet, a low-temperature sintered ceramic green sheet composed of SiO₂, Al₂O₃, BaO, B₂O₃ and a binder was used. In addition, a nonreducing dielectric paste was used as a dielectric paste. As a resistor paste, a nonreducing resistor paste composed mainly of LaB₆ was used. A conductor paste of Cu group was used as a conductive paste. Then, respective paste layers were formed by a screen printing process. The entire paste layers and so on were pressed and fired at 950°C in a nitrogen atmosphere.

Capacities and resistances measured for each sample by means of an LCR meter have shown the designed values.

As the conventional example, 200 samples were prepared by a method in which an insulator spacer is not formed as compared with the respective manufacturing methods A, B and C aforementioned.

For all samples, the delamination rate during firing and the surface smoothness after firing were checked. In this case, as to the surface smoothness, a maximum surface waviness was measured by a stylus-type surface roughness meter according to JIS-B0610 (high-range cut off value 0.8mm, reference length 25mm). Results are shown in the following Table:

**TABLE**

| | Sample by Method A | Sample by Method B | Sample by Method C | Sample of Conventional Example |
|---|---|---|---|---|
| Delamination Rate (%) | 0.4 | 0.5 | 0.5 | 27.5 |
| Maximum Surface Waviness | 21.5 | 20.2 | 19.5 | 295 |

From the table, according to the product of the present invention and illustrative products, as compared with the conventional example, it is understood that the delamination rate during firing is reduced sharply and the surface smoothness after firing is improved considerably.

While the present invention has been particularly described and shown, it is to be understood that it is for the purpose of illustration and example and not for limitation.

## Claims

1. A method for manufacturing a multilayer ceramic substrate which contains a circuit element, the method comprising:
making a first ceramic green sheet having first and second main surfaces, from a material which is selected to form an insulator substrate upon firing;
forming a circuit element paste layer from a material which is selected to form a circuit element upon firing on a portion of the first main surface of said ceramic green sheet;
forming an insulator material layer from a material which is selected to form an insulator spacer upon firing, at least on another portion of said first main surface of said ceramic green sheet, so as to form a generally smooth surface in cooperation with said circuit element paste layer;
making a separate second ceramic green sheet from a material which is selected to form a separate second insulator substrate upon firing;
forming a laminate by laminating said separate ceramic green sheet on said smooth surface; and
pressing and firing said laminate;
said forming of said insulator material layer including forming an insulator layer on the other portion of the first main surface of ceramic green sheet on said circuit element paste so as to make a surface of said insulator layer generally smooth,
and
said forming of said laminate including laminating said separate ceramic green sheet on said insulator paste layer.

2. A method for manufacturing a multilayer ceramic substrate in accordance with claim 1,
wherein said forming said insulator layer includes printing an insulator paste on the other portion of the first main surface of said ceramic green sheet and on said circuit element paste layer.

3. A method for manufacturing a multilayer ceramic substrate in accordance with claim 1,
wherein said forming said insulator material layer includes making an insulator ceramic green sheet which is thicker than said circuit element paste layer, and opposing said circuit element paste layer, has a recess of generally the same size as said circuit element paste layer, and
laminating said insulator ceramic green sheet on the other portion of the first main surface of said ceramic green sheet and said circuit element paste layer, and furthermore
said forming of said laminate includes laminating said separate ceramic green sheet on said insulator ceramic green sheet.

4. A method for manufacturing a multilayer ceramic substrate in accordance with claim 1, further comprising the step of forming a conductor at least on said first ceramic green sheet which connects said circuit element to the exterior of said multilayer ceramic substrate.

5. A method for manufacturing a multilayer ceramic substrate in accordance with claim 1, wherein said circuit element is selected from the group consisting of resistive and reactive circuit elements.

## Patentansprüche

1. Verfahren zur Herstellung eines mehrschichtigen keramischen Substrates, welches ein Schaltungselement enthält, wobei das Verfahren umfaßt:
Herstellen eines ersten keramischen ungebrannten Streifens, der erste und zweite Hauptflächen aufweist, aus einem Material, das ausgewählt ist, ein Isolatorsubstrat nach dem Brennen zu bilden;
Bilden einer Pastenschicht für das Schaltungselement aus einem Material, das ausgewählt ist, ein Schaltungselement nach dem Brennen auf einem Abschnitt der ersten Hauptfläche des keramischen ungebrannten Streifens zu bilden;
Bilden einer Isolatormaterialschicht aus einem Material, das ausgewählt ist, einen Isolator-Abstandsstück nach dem Brennen wenigstens auf einem anderen Abschnitt der ersten Hauptfläche des keramischen ungebrannten Streifens zu bilden, so daß eine im allgemeinen glatte Oberfläche zusammen mit der Pastenschicht für das Schaltungselement gebildet wird;
Herstellen eines separaten zweiten keramischen ungebrannten Streifens aus einem Material, das ausgewählt ist, ein separates zweites Isolatorsubstrat nach dem Brennen zu bilden;
Bilden eines Schichtsubstrates durch das Laminieren des separaten keramischen ungebrannten Streifens auf der glatten Oberfläche; und
Pressen und Brennen des Schichtsubstrates;
wobei das Bilden der Isolatormaterialschicht das Bilden einer Isolatorschicht auf dem anderen Abschnitt der ersten Hauptfläche des keramischen ungebrannten Streifens auf der Schaltungselementpaste umfaßt, so daß eine im allgemeinen glatte Oberfläche auf der Isolatorschicht erzeugt wird, und
das Bilden des Schichtsubstrates das Laminieren des separaten keramischen ungebrannten Streifens auf die Isolatorpastenschicht umfaßt.

2. Verfahren zur Herstellung eines mehrschichtigen keramischen Substrates nach Anspruch 1, wobei das Bilden der Isolatorschicht das Drucken einer Isolatorpaste auf dem anderen Abschnitt der ersten Hauptfläche des keramischen ungebrannten Streifens und auf der Pastenschicht für das Schaltungselement umfaßt.

3. Verfahren zur Herstellung eines mehrschichtigen keramischen Substrates nach Anspruch 1, wobei das Bilden der Isolatormaterialschicht das Herstellen eines keramischen ungebrannten Isolatorstreifens umfaßt, welcher dicker ist als die Pastenschicht für das Schaltungselement, und, der Pastenschicht für das Schaltungselement gegenüberliegend, eine Aussparung von im allgemeinen derselben Größe aufweist wie die Pastenschicht für das Schaltungselement, sowie
Laminieren des keramischen ungebrannten Isolatorstreifens auf den anderen Abschnitt der ersten Hauptfläche des keramischen ungebrannten Streifens und auf der Pastenschicht für das Schaltungselement, und ferner
das Bilden des Schichtsubstrates das Laminieren des separaten keramischen ungebrannten Streifens auf der keramischen ungebrannten Isolatorschicht umfaßt.

4. Verfahren zur Herstellung eines mehrschichtigen keramischen Substrates nach Anspruch 1, das ferner den Schritt des Bildens eines elektrischen Leiters wenigstens auf dem ersten keramischen ungebrannten Streifen umfaßt, der das Schaltungselement mit dem Äußeren des mehrschichtigen keramischen Substrates verbindet.

5. Verfahren zur Herstellung eines mehrschichtigen keramischen Substrates nach Anspruch 1, wobei das Schaltungselement aus der Gruppe ausgewählt ist, die aus Widerstands- und Reaktanz-Schaltungs-elementen besteht.

## Revendications

1. Procédé pour la fabrication d'un substrat céramique multicouche qui contient un élément de circuit, le procédé comprenant les étapes consistant :
à fabriquer une première feuille céramique à l'état vert présentant des première et seconde surfaces principales à partir d'un matériau qui est choisi pour former un substrat isolant par cuisson ;
à former une couche de pâte d'élément de circuit à partir d'un matériau qui est choisi pour former un élément de circuit par cuisson sur une partie de la première surface principale de ladite feuille céramique à l'état vert ;
à former une couche de matériau isolant à partir d'un matériau qui est choisi pour former un élément d'écartement isolant par cuisson, au moins sur une autre partie de ladite première surface principale de ladite feuille céramique à l'état vert afin de former une surface en général lisse en coopération avec ladite couche de pâte d'élément de circuit ;
à fabriquer une seconde feuille céramique à l'état vert séparée à partir d'un matériau qui est choisi pour former un second substrat isolant séparé par cuisson ;
à former un stratifié en stratifiant ladite feuille céramique à l'état vert séparée sur ladite surface lisse ; et
à comprimer et à cuire ledit stratifié ;
ladite formation de ladite couche de matériau isolant comprenant la formation d'une couche isolante sur l'autre partie de la première surface principale de la feuille céramique à l'état vert sur ladite pâte d'élément de circuit afin de fabriquer une surface de ladite couche isolante en général lisse,
et
ladite formation dudit stratifié comprenant la stratification de ladite feuille céramique à l'état vert séparée sur ladite couche de pâte isolante.

2. Procédé pour la fabrication d'un substrat céramique multicouche selon la revendication 1,
dans lequel ladite formation de ladite couche isolante comprend l'impression d'une pâte isolante sur l'autre partie de la première surface principale de ladite feuille céramique à l'état vert et sur ladite couche de pâte d'élément de circuit.

3. Procédé pour la fabrication d'un substrat céramique multicouche selon la revendication 1,
dans lequel ladite formation de ladite couche de matériau isolant comprend la fabrication d'une feuille céramique à l'état vert isolante qui est plus épaisse que ladite couche de pâte d'élément de circuit et étant opposée à ladite couche de pâte d'élément de circuit, présente un creux en général de la même taille que ladite couche de pâte d'élément de circuit, et
la stratification de ladite feuille céramique à l'état vert isolante sur l'autre partie de la première surface principale de ladite feuille céramique à l'état vert et ladite couche de pâte d'élément de circuit, et
ladite formation dudit stratifié comprend en outre la stratification de ladite feuille céramique à l'état vert séparée sur ladite feuille céramique à l'état vert isolante.

4. Procédé pour la fabrication d'un substrat céramique multicouche selon la revendication 1, comprenant en outre l'étape consistant à former un conducteur au moins sur ladite première feuille céramique à l'état vert qui connecte ledit élément de circuit à l'extérieur dudit substrat céramique multicouche.

5. Procédé pour la fabrication d'un substrat céramique multicouche selon la revendication 1, dans lequel ledit élément de circuit est choisi parmi des éléments de circuit ohmiques et réactifs.
